# EUROPEAN PATENT SPECIFICATION

(11) **EP 3 499 120 B1**
(45) Date of publication and mention of the grant of the patent: **28.10.2020**
(21) Application number: 18212208.5
(22) Date of filing: 13.12.2018
(51) Int. Cl.: F21V 31/04, F21K 9/233, F21K 9/238, H05K 1/02, F21Y 115/10, F21W 131/40

(54) **IMPROVED HEAT DISSIPATION IN A LED LAMP**
VERBESSERTE WÄRMEABFUHR IN EINER LED-LAMPE
DISSIPATION DE CHALEUR AMÉLIORÉE DANS UNE LAMPE À DEL

(30) Priority: 14.12.2017 FI 20176119
(43) Date of publication of application: 19.06.2019
(73) Proprietor: NetMens Solutions Oy, 48200 Kotka (FI)
(72) Inventor: JUSTEN, Jarmo, 02400 Kirkkonummi (FI); KOSKINEN, Timo, 00430 Helsinki (FI)
(74) Representative: Boco IP Oy Ab

(56) References cited:
- DE-A1- 3 430 540
- JP-A- 2014 212 121
- US-A1- 2007 114 555
- US-A1- 2013 314 920
- US-B2- 9 282 634

## Description

### Field

The present invention relates to an apparatus and a method related to LED lamps. More particularly, the present invention relates to a LED lamp apparatus and a method therein improving heat dissipation.

### Background

An LED lamp is an electric light or light bulb for use in lighting fixtures that produces light using light-emitting diodes (LEDs). LED lamps have a lifespan and electrical efficiency which are several times greater than for example incandescent, halogen or fluorescent lamps.

LED chips typically use controlled direct current (DC) electrical power and an appropriate circuit as an LED driver is required to provide the LED chip the electricity in suitable form.

Although the electrical efficiency of a LED lamps is good, LEDs do generate heat. LEDs are adversely affected by high temperature, so LED lamps typically include heat dissipation elements such as heat sinks and cooling fins. However, miniaturizing the heat dissipation elements is a challenge, the complexity of which increases if the LED lamp is designed to be used in hot environment. One example of such hot environment is sauna, where air temperature may easily exceed 100°C. In addition to being hot, the environmental conditions in a sauna are also humid, which further adds requirements for the protection.

### Description of the related art

A typical solution for dissipating heat away from a LED is to place the LED on a heat sink base. Such heat sink base, however, needs a wide area, which increases the size of the LED lamp.

US 2007/0114555 A1 discloses a light emitting element including a LED lamp, with a metallic reflecting plate and a heat radiating sheet to radiate heat generated at the reflecting plate.

JP 2012004195 A disclose a flexible substrate module for a LED device, that has a heat source that performs heat transfer to printed wiring layer.

JP 2014212121 A discloses a housing for a LED lamp that restrains temperature rise.

DE 3430540 A1 discloses an indicator lamp.

### Summary

An object is to provide a method and apparatus so as to solve the problem of improving heat dissipation in a LED lamp. The objects of the present invention are achieved with an apparatus according to the characterizing portion of claim 1. The objects of the present invention are further achieved with a method according to the characterizing portion of claim 7.

The preferred embodiments of the invention are disclosed in the dependent claims.

The present invention is based on the idea of an improved printed circuit board structure which effectively conducts heat away from the LED. The heat dissipation is further improved by heat conducting filling used for sealing the LED lamp structure, which conducts diffused heat to the body of the LED lamp for dissipation.

According to a first aspect, A LED lamp is provided. The LED lamp comprises a metal body, a printed circuit board, a LED, wiring and a multi-layer circuit board. The metal body has a cylindric lumen. The printed circuit board has a plurality of installation holes. The LED is disposed within the metal body near a distal end of the metal body, and the LED is electrically coupled to a top layer of the printed circuit board. The wiring provides energy to the LED. The wiring is coupled to the printed circuit board at the plurality of installation holes, and the wiring extends from a proximal end of the metal body. The multi-layer printed circuit board is fitted within the cylindric lumen near the distal end of the metal body. The multi-layer printed circuit board is configured to facilitate dissipation of heat from the LED. The multi-layer printed circuit board further comprises a middle metal layer sandwiched between a first layer of PCB material and a second layer of PCB material. The middle metal layer is configured to collect heat and to conduct heat towards the wiring: the multi-layer printed circuit board further comprises a bottom metal layer disposed at or near the face of the printed circuit board that faces towards the proximal end of the metal body. The bottom metal layer is configured to collect diffused heat. The proximal end of the cylindric lumen is filled with heat conducting filling configured to conduct heat collected by the bottom metal layer towards the metal body.

According to a second aspect, the distal end of the cylindric lumen is filled with optical filling sealing the LED and the printed circuit board from the environment in the distal end of the body. The heat conducting filling seals the printed circuit board from the environment in the proximal end of the body.

According to a third aspect, the installation holes traverse through the printed circuit board. Two conductors of the wiring are coupled to the printed circuit board with two metal cable connectors, each cable connector having one end disposed in one of the installation holes and other end coupled with the wiring. The cable connectors are mechanically and electrically coupled with the printed circuit board by filling the installation holes with solder material, and wherein the cable connectors further conduct heat from the middle metal layer to the wiring.

According to a fourth aspect, the middle metal layer comprises two electrically separate parts of metal coating, each electrically coupled to one of the cable connectors. The combined area of the two parts of the middle metal layer essentially covers the entire area of the middle metal layer.

According to the invention, the bottom metal layer comprises two solder pad parts and a heat conducting part electrically uncoupled from the two solder pads. The heat conducting part covers majority of the area of the bottom metal layer not covered by the solder pads. The heat conducting part is configured to collect diffused heat from the printed circuit board and to conduct the received diffused heat away from the printed circuit board via the heat conducting filling.

According to a fifth aspect, the top metal layer and the middle metal layer are separated by a first layer of PCB material and the middle metal layer and the bottom layer are separated by a second layer of PCB material. The second layer is thicker than the first layer.

According to a sixth aspect, the bottom metal layer is further separated from the proximal face of the printed circuit board by a third layer of PCB material. The third layer is thinner than the second layer.

According to another aspect, a method of dissipating heat in a LED lamp is provided. The LED lamp comprises a metal body with a cylindric lumen, a printed circuit board with a plurality of installation holes, a LED disposed within the metal body near a distal end of the metal body, wiring providing energy to the LED and a multi-layer printed circuit board. The wiring is coupled to the printed circuit board at the plurality of installation holes, and the wiring extends from a proximal end of the metal body. The multi-layer printed circuit board is fitted within the cylindric lumen near the distal end of the metal body and configured to facilitate dissipation of heat from the LED. The method comprises collecting heat by a middle metal layer sandwiched between a first layer of PCB material and a second layer of PCB material and conducting the collected heat towards the wiring by the middle metal layer; collecting diffused heat by a bottom metal layer disposed at or near the face of the printed circuit board that faces towards the proximal end of the metal body, and conducting heat collected by the bottom metal layer towards the metal body via heat conducting filling disposed in the proximal end of the cylindric lumen. The bottom metal layer comprises two solder pad parts and a heat conducting part electrically uncoupled from the two solder pads, wherein the heat conducting part covers majority of the area of the bottom metal layer not covered by the solder pads, and the method further comprises collecting diffused heat from the printed circuit board by the heat conducting part, and conducting the received diffused heat away from the printed circuit board via the heat conducting filling.

The present invention has the advantage that using the improved heat dissipating structure, a very compact LED lamp may be manufactured that may be used in harsh environmental conditions. Especially the improved heat dissipation of the structure enables a miniature LED lamp which may be used in hot environments such as in saunas or outdoors even in high and humid temperatures present for example in tropical surroundings. The LED lamp is also well protected from dust and humidity.

### Brief description of the drawings

In the following the invention will be described in greater detail, in connection with preferred embodiments, with reference to the attached drawings, in which
The figure 1 is a simplified illustration of the basic structure of a LED lamp.
The figure 2 illustrates an exemplary body 200 of the LED lamp.
Figures 3a to 3c illustrate examples of different embodiments on the body
The figure 4 illustrates schematically shape of a multi-layered printed circuit board PCB.
The figure 5 illustrates a printed circuit board disposed within a body of a LED lamp.
The figure 6 illustrates installation of cable connectors.
The figure 7 illustrates layouts of three metal layers.
The figure 8 illustrates layouts of three metal layers.
The figure 9 illustrates a perspective view of a multi-layer printed circuit board.
The figure 10 illustrates a cross section of a LED lamp.

### Detailed description

Following description illustrates the main characteristics of the current invention with help of the drawings. It should be noticed, that the drawings are not in scale, and some dimensions in the drawings have been exaggerated for visualization.

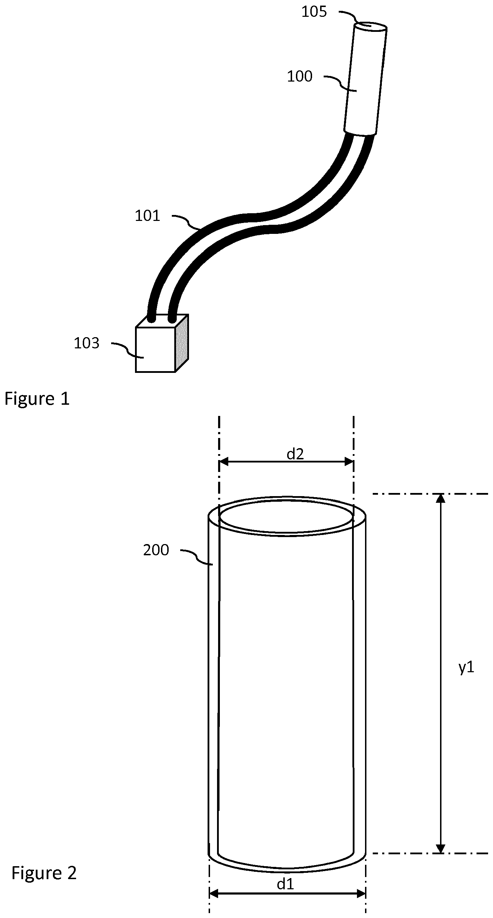

The figure 1 is a simplified illustration of the basic structure of a LED lamp according to the invention. The LED lamp 100 preferably comprises an essentially cylinder formed body with the LED 105 disposed at one end of the body. The LED lamp 100 is coupled to a connector 103 with two electrically conductive wires 101. Alternatively, there could be just a single wire with two conductors within common insulation material. In such case, the wire insulation is split for coupling each conductor. The term wiring refers to any type of wires providing the needed anode and cathode connections needed to power the DC operated LED 105. The connector 103 is configured to couple the LED lamp 100 to a DC electrical power source. The electrically conductive wires 101 are covered preferably with heat resistant insulating material, such as silicone. This type of wires 101 are able to handle temperatures at least up to 200°C. In the following description, the end of the LED lamp 100 with the LED 105 is called distal end of and the end of the LED lamp 100 with the wires 101 towards the connector 103 is called as the proximal end.

The figure 2 illustrates an exemplary body 200 of the LED lamp. This exemplary body 200 is formed as a hollow cylinder. The body may also be characterized as a tube with a circular lumen. The body 200 is designed to facilitate easy installation of the LED lamp. The body 200 is made of heat conducting material. Preferably, the body 200 is made of metal. More preferably, the body is made of aluminum, which has suitable heat conducting properties for its intended use. In addition, aluminum is lightweight and robust enough to protect the assembly inside the body mechanically during assembly and use of the LED lamp. In the preferred embodiment, the body is made of anodized aluminum. The body 200 may be coated with a thin layer of other metal. For example, a thin layer of copper may be applied on the cylinder. The body 200 is configured to conduct heat from the LED lamp installation that is disposed within the body. The outer diameter d1 of the body defines the size of the installation holes needed for the LED lamp. The inner diameter d2 and the length y1 of the body 200 defines a volume inside the cylinder, which is available for the LED lamp components. In an exemplary embodiment, the outer diameter d1 is 6 mm and the inner diameter d2 is 5 mm. Further, in an exemplary embodiment the total length of the body 200 may be for example 14 mm.

The outer surface of the body 200 does not have to be uniform. For facilitating installation of the LED lamp, the outer periphery of the body may comprise for example screw thread, which may be carved into the body, or which may protrude from the outer periphery of the otherwise cylinder formed body. Alternatively, or in addition, the outer periphery of the body may comprise a collar facilitating control of installation depth of the LED lamp. The volume within the body 200 preferably forms a cylinder.

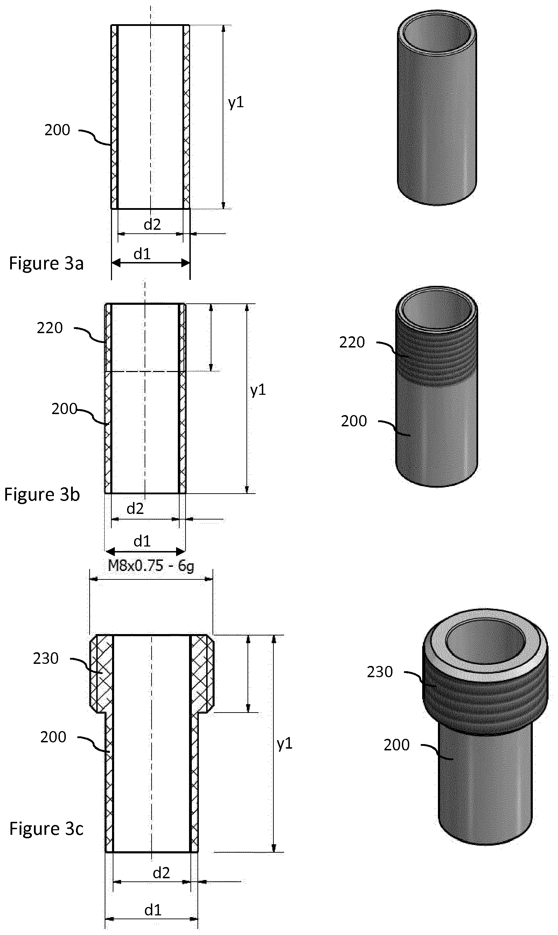

Figures 3a to 3c illustrate examples of different embodiments on the body. The figure 3a shows a cross-section and a perspective view of a simple, smooth cylinder formed body 200. The figure 3b shows a cross-section and a perspective view of a body 200 with screw thread 220 carved to the outer periphery of the distal end of the body. The figure 3c illustrates a cross-section and a perspective view of a body 200 with a collar 230 disposed on the outer periphery of the distal end of the body 200, the collar 230 extending the diameter of the body near the distal end of the body. The collar may be smooth, or it may also have a screw thread as shown in the figure 3c. In the exemplary embodiments, the length y1 of the body may be for example 14 mm, and the length of the collar and/or the screw thread may be for example 5 mm.

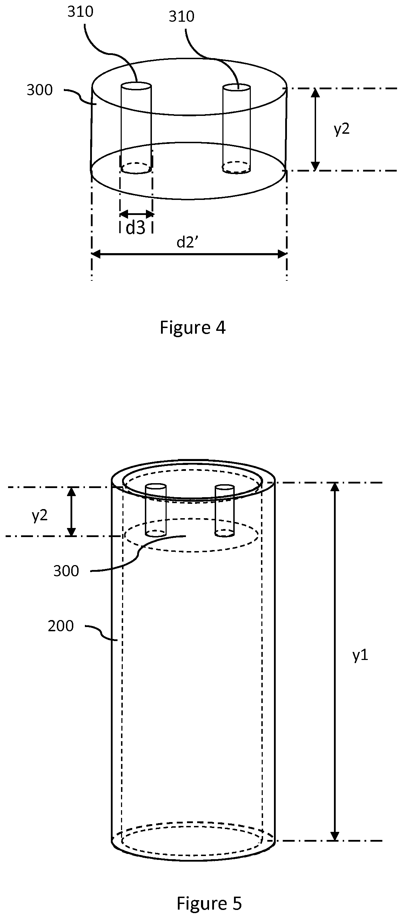

The figure 4 illustrates schematically shape of a multi-layered printed circuit board PCB (300) which is one of the main elements of the preferred embodiment. The printed circuit board 300 is cut into an essentially circular form with a diameter d2' equal to or slightly less than the inner diameter d2 of the body so that the printed circuit board may be fitted within the cylinder form volume within the body. In an exemplary embodiment, the diameter d2' of the printed circuit board 300 is 4,9 mm. The thickness y2 of the printed circuit board 300 is preferably less than half of the length of the body. Thickness refers to the dimension of the essentially flat printed circuit board intended to be aligned with the longitudinal axis of the lumen. The term area refers to the lateral dimension of the printed circuit board, which is limited by the inner walls of the lumen of the body, when the printed circuit board is installed in its intended position within the body. Shape of the area of the printed circuit board is thus essentially circular within the circular lumen. The printed circuit board 300 is configured to be installed inside the body. The printed circuit board 300 also has two installation holes with diameter d3 310 drilled though it. The installation holes 310 serve dual purposes, which will be explained later. In one exemplary embodiment, the printed circuit board is about 1 mm thick, and the installation holes have a diameter d3 of 0.7 mm.

The figure 5 illustrates the printed circuit board 300 disposed within the body 200. The printed circuit board 300 is disposed at one end of the body 200. The LED (not shown) is disposed on the surface of the printed circuit board 300 that resides towards the distal end of the body 200 at which the printed circuit board is disposed at, so that the LED is inside the lumen of the body 200.Thus, the top surface of the printed circuit board 300 is disposed at or near the distal end of the body. The top surface thus preferably remains slightly below the distal end of the body to ensure that the LED remains inside the lumen. The small volume inside the body 200 at the distal end may be filled with optical filling, in other words with a mass that mechanically protects the PCB surface and the LED installed on it, but is highly transparent so that light from the LED passes with high transmission rate. The optical filling may comprise for example clear silicone which cures at room temperature. A silicone optical filling also has good adhesive properties, which facilitate protection of the LED from dust and moisture required in challenging environment while also attaching the printed circuit board with the body. For example, an electrical device intended to be used in sauna environment should fulfill IP67 criteria given in so called IP Codes (International Protection Marking), which are defined in the IEC standard 600529 by the International Electrotechnical Commission (IEC). The type of LED used in the LED lamp is preferably one packaged in a micro footprint, surface mount package with a low, flat profile.

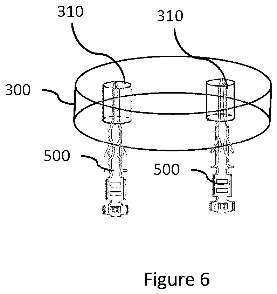

The figure 6 illustrates installation of cable connectors 500 in the installation holes 310 of the printed circuit board 300 according to an exemplary embodiment. The two electrical wires illustrated for example in the figure 1 are connected to the LED assembly disposed within the body with two cable connectors 500. The cable connectors 500 are designed for conducting both electricity and heat. One end of the cable connectors 500 are disposed in the installation holes 310, and soldered into the printed circuit board 300 so that the solder paste fills the installation holes, while the remainder of the cable connectors 500 below the printed circuit board 300 are configured for coupling of electrical wires. The cable connectors 500 are made of metal. For example, the connectors may be made from phosphor bronze alloy, and they may further be at least partially plated with a thin layer of other metal, for example gold, tin, or nickel. This type of cable connectors is widely commercially available. One suitable cable connector 500 that may be used in the exemplary embodiment is Micro-Fit 3.0 male terminal by Molex. The narrow tip part of this specific connector type should be long enough to be safely soldered with the printed circuit board 300, and the diameter of the holes 310 should also be designed to facilitate a good mechanical and electrical joint between the cable connector 500 and the printed circuit board. The invention is not limited to any specific type of cable connectors, but any suitable cable connectors may be used. Further, in an alternative embodiment, the protecting coating may simply be peeled at the distal ends of the wires, and the metal conductor of the wires is directly soldered in the installation holes. A structure without cable connectors is, however, less attractive mechanically and thermodynamically as well as inferior in view of industrial manufacturability.

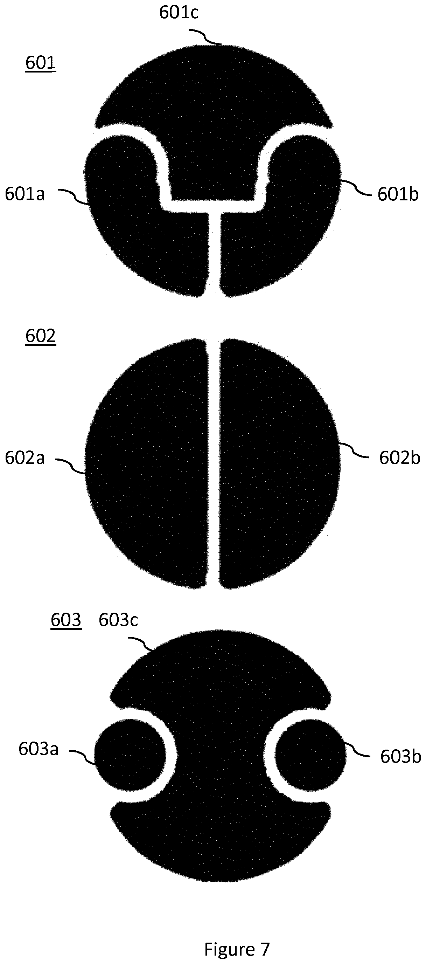

The figures 7, 8 and 9 illustrate the structure of the printed circuit board in more detail. The printed circuit board comprises a plurality of layers. The printed circuit board may comprise layers of PCB material, such as common fiberglass-reinforced epoxy laminates known as FR4, and thin, a plurality patterned metal layers are disposed on the printed circuit board. Alternatively, the PCB material may be any suitable laminate, copper-clad laminate or resin impregnated B-stage cloth known in the art, for example FR5, FR6, G10 or CEM materials to mention a few. In the following example, the printed circuit board comprises two or three layers of PCB material and three layers of metal. The metal layers may have thickness of 0.35 µm commonly used in printed circuit boards. The thickness of the layers of PCB material is optimized for heat conducting purposes.

The figure 7 illustrates initial layouts of three metal layers (601, 602, 603) of the essentially circular printed circuit board. The top metal layer 601 is disposed on the top surface of the printed circuit board so that the metal patterns are exposed. The top surface is disposed towards the distal end of the LED lamp. The top layer 601 provides an exposed metal surface divided into three parts, which are electrically separated from each other. First parts 601a and 601b of the metal pattern on the top layer 601 represent the areas on which the LED device is to be coupled to by soldering. The middle metal layer 602 is sandwiched between two layers of PCB material. The two parts 602a and 602b of the metal pattern of the middle metal layer 602 essentially cover the entire cross-section of the PCB, and are electrically separated from each other. The middle metal layer 602 has no direct electrical function, but it acts as a heat receiving layer, from which the heat emitted by the LED is conducted to the wires. The metal area of the middle metal layer 602 is maximized for effective heat collection. The bottom metal layer 603 is disposed at or near the bottom face (proximal face) of the PCB that faces towards the proximal end of the body of the LED lamp. The bottom layer 603 comprises solder pad parts 603a and 603b configured to be coupled with the cable connectors with the solder disposed in the installation holes 130, and a heat conducting part 603c configured to conduct diffused heat from the printed circuit board via heat conducting mass towards the body of the LED lamp. Diffused heat may refer for example to heat diffused to the PCB material layers that is not conducted away by the middle metal layer 602. The heat conducting part 603c serves only thermal purposes. Thus, it may be electrically uncoupled from the wiring and the cable connectors.

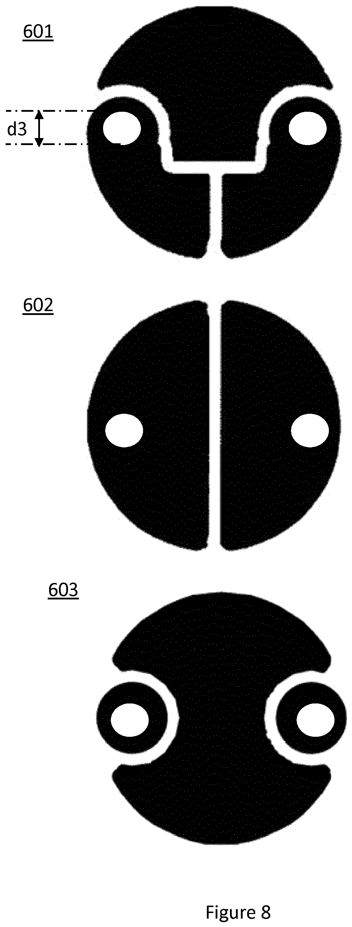

The figure 8 illustrates layouts of the three metal layers (601, 602, 603) of the essentially circular printed circuit board when the installation holes have been drilled. The metal layers have circular holes with diameter d3, into which the cable connectors will be disposed. The diameter d3 of the holes in the metal layers correspond to that of the installation holes. When the installation holes are filled with solder, any parts into which the holes were made in the printed circuit board become electrically coupled with the cable connectors.

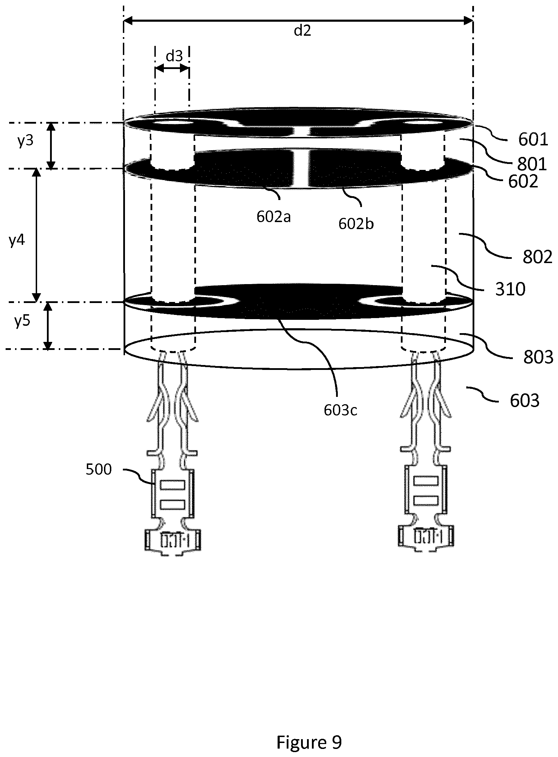

The figure 9 illustrates a perspective view of the printed circuit board 300. The drawing is not in scale, and the height of the structure has been exaggerated for visualization. The installation holes 310 traverse through the PCB. The cable connectors 500 are coupled into the installation holes 310 with solder paste. Preferably, the cable connectors 500 traverse through the entire thickness of the PCB, and are soldered from the top side of the PCB, in other words from the side of the PCB that faces the distal end of the LED lamp. The solder paste filling the installation holes 310 couples the cable connectors, three metal layers (601, 602, 602) electrically and thermodynamically. The structure is configured to effectively conduct heat generated by the LED away from the LED. The middle layer 602 includes one key feature of the invention. Layers of the printed circuit board have different thicknesses. The first layer 801 of PCB material between the top metal layer 601 and the middle metal layer 602 is clearly thinner than the second layer 802 of PCB material between the middle metal layer 602 and the bottom metal layer 603. In other words, thickness y4 of the second layer 802 is more than the thickness y3 of the first layer 801. In an exemplary embodiment, the thickness y3 of the first layer 801 is 0.1mm, and the thickness y4 of the second layer is 0.7mm.

According to the invention, the PCB structure causes the heat generated by the LED to be conducted effectively to the wires through the layers of the PCB. The metal parts of the middle metal layer 602 are relative close to the LED coupled to the top metal layer 601, and the middle metal layer 602 is configured to conduct the heat generated by the LED to the wires via the solder paste and the cable connectors 500. The structure facilitates effective conduction of heat. Heat is conducted from the LED through the electrical coupling between the LED and the wires, as well as by the effective collection of heat by the middle metal layer 602.

Further, diffused heat is collected and conducted towards the body via the third part of the bottom metal layer 603. The thickness y5 of the third PCB material layer 803 disposed between the bottom metal layer 603 and the bottom surface of the printed circuit board is preferably less than the thickness of the second layer 802 of PCB material. In one embodiment the thickness y5 of the third layer 803 is equal to that of the first layer 801. In another embodiment the thickness of the third PCB material layer is zero, so that the bottom metal layer is exposed at the proximal surface of the printed circuit board 300.

For further improving conduction of diffused heat, the remaining free volume within the lumen within the body is filled with heat conducting filling material. The heat conducting material may be for example room-temperature-vulcanizing silicone, often referred to as silicone RTV, which is a type of silicone rubber. A silicone RTV with low thermal resistance is typically used for filling a gap between a device and a heat sink, but it is also applicable to be used as an adhesive and sealant. The diffused heat collected by the third part of the bottom metal layer 603 is conducted effectively the via the heat conducting filling material to the body. In addition, the heat conducting filling further ensures attachment of the printed circuit board with the body.

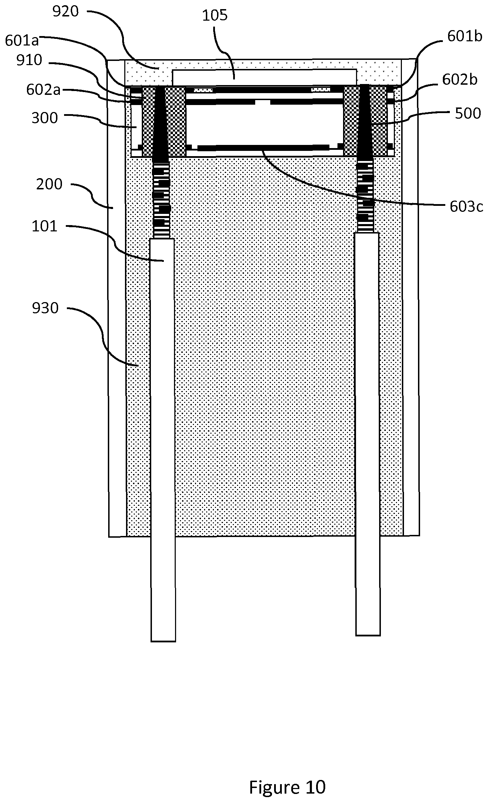

The figure 10 illustrates a cross-section of the LED lamp. The LED 105 is attached on the distal face of the printed circuit board 300, more specifically to the first parts 601a and 601b of the top metal layer 601 of the printed circuit board 300. The printed circuit board 300 is disposed within the volume of the body 200, and wiring 101 is coupled to the printed circuit board with two cable connectors 500, which are coupled with the printed circuit board 300 with solder 910 filling the installation holes. An optical filling 920 is applied that fills the remaining volume within the lumen in the distal end of the body 200. The wiring 101, in this example implemented with two separate, insulated wires, is coupled to the cable connectors 500. The wiring traverses through the proximal part of the lumen. The proximal part of the lumen is filled with heat conducting filling 930, which seals the printed circuit board as well as the cable connectors and the wire contacts thereof within the lumen in the body 200. The solder 910 couples electrically with the two parts 602a and 602b of the metal pattern of the middle metal layer 602 but not to the heat conducting part 603c of the bottom metal layer.

Measurements have been performed by the inventors to ensure that the structure fulfills given thermodynamic criteria. Measurements show that the structure works well even with 300mA DC current, but typically clearly lower current is needed for providing sufficiently bright light with the LED lamp. For example, a typical application may use 150mA DC current, and the LED lamp according to the invention does not significantly heat due to such current, although it may heat due to high temperature of the ambient environment. With the improved heat dissipating structure, the LED lamp tolerates well such external heat. The LED lamp according to the preferred embodiment may thus be used in a broad range of ambient temperatures. With the heat tolerance combined good IP protection, the LED lamp according to the invention may be used both indoors and outdoors, and also in sauna environment.

It is apparent to a person skilled in the art that as technology advanced, the basic idea of the invention can be implemented in various ways. The invention and its embodiments are therefore not restricted to the above examples, but they may vary within the scope of the claims.

## Claims

1. A LED lamp (100 comprising:
- a metal body (200) with a cylindric lumen;
- a printed circuit board (300) with a plurality of installation holes (310);
- a LED (105) disposed within the metal body (200) near a distal end of the metal body, the LED electrically coupled to a top layer of the printed circuit board;
- wiring (101) providing energy to the LED, wherein the wiring is coupled to the printed circuit board at the plurality of installation holes (310), and wherein the wiring extends from a proximal end of the metal body;
wherein the multi-layer printed circuit board is fitted within the cylindric lumen near the distal end of the metal body (200), and wherein the multi-layer printed circuit board is configured to facilitate dissipation of heat from the LED (105), the multi-layer printed circuit board further comprising:
- a middle metal layer (602) sandwiched between a first layer of PCB material (801) and a second layer of PCB material (802), wherein the middle metal layer is configured to collect heat and to conduct heat towards the wiring (101); and
- a bottom metal layer (603) disposed at or near the face of the printed circuit board that faces towards the proximal end of the metal body (200), wherein the bottom metal layer is configured to collect diffused heat;
wherein the proximal end of the cylindric lumen is filled with heat conducting filling (930) configured to conduct heat collected by the bottom metal layer (603) towards the metal body (200),
**characterized in that** the bottom metal layer (603) comprises two solder pad parts (603a, 603b) and a heat conducting part (603c) electrically uncoupled from the two solder pads (603a, 603b), wherein the heat conducting part (603c) covers majority of the area of the bottom metal layer (603) not covered by the solder pads (603a, 603b), and wherein the heat conducting part (603c) is configured to collect diffused heat from the printed circuit board (300) and to conduct the received diffused heat away from the printed circuit board via the heat conducting filling (930).

2. The LED lamp according to claim 1, wherein the distal end of the cylindric lumen is filled with optical filling (920) sealing the LED (105) and the printed circuit board (300) from the environment in the distal end of the body, while the heat conducting filling (930) seals the printed circuit board (300) from the environment in the proximal end of the body.

3. The LED lamp according to any of claims 1 to 2, wherein the installation holes (310) traverse through the printed circuit board (300), and two conductors of the wiring are coupled to the printed circuit board with two metal cable connectors (500), each cable connector having one end disposed in one of the installation holes (310) and other end coupled with the wiring (101), wherein the cable connectors are mechanically and electrically coupled with the printed circuit board by filling the installation holes (310) with solder material, and wherein the cable connectors (500) further conduct heat from the middle metal layer (602) to the wiring (101).

4. The LED lamp according to any of claims 1 to 3, wherein the middle metal layer (602) comprises two electrically separate parts of metal coating, each electrically coupled to one of the cable connectors (500), wherein the combined area of the two parts of the middle metal layer covers majority of the area of the middle metal layer.

5. The LED lamp according to any of claims 1 to 4, wherein the top metal layer (601) and the middle metal layer (602) are separated by a first layer of PCB material (801) and the middle metal layer (602) and the bottom layer (603) are separated by a second layer of PCB material (802), wherein the second layer (802) is thicker than the first layer (801).

6. The LED lamp according to claim 5, wherein the bottom metal layer (603) is further separated from the proximal face of the printed circuit board by a third layer of PCB material (803), wherein the third layer (803) is thinner than the second layer (802).

7. A method of dissipating heat in a LED lamp comprising a metal body (200) with a cylindric lumen, a printed circuit board (300) with a plurality of installation holes (310), a LED (105) disposed within the metal body near a distal end of the metal body, wiring (101) providing energy to the LED, wherein the wiring is coupled to the printed circuit board (300) at the plurality of installation holes (310), and wherein the wiring extends from a proximal end of the metal body (200), and wherein the multi-layer printed circuit board (300) is fitted within the cylindric lumen near the distal end of the metal body (200) and configured to facilitate dissipation of heat from the LED (105), wherein the method comprises:
- collecting heat by a middle metal layer (602) sandwiched between a first layer of PCB material (801) and a second layer of PCB material (802), and conducting the collected heat towards the wiring (101) by the middle metal layer (602);
- collecting diffused heat by a bottom metal layer (603) disposed at or near the face of the printed circuit board (300) that faces towards the proximal end of the metal body; and
- conducting heat collected by the bottom metal layer (603) towards the metal body (200) via heat conducting filling (930) disposed in the proximal end of the cylindric lumen,
**characterized in that** the bottom metal layer (603) comprises two solder pad parts (603a, 603b) and a heat conducting part (603c) electrically uncoupled from the two solder pads (603a, 603b), wherein the heat conducting part covers majority of the area of the bottom metal layer (603) not covered by the solder pads, and wherein the method further comprises:
- collecting diffused heat from the printed circuit board by the heat conducting part (603c), and
- conducting the received diffused heat away from the printed circuit board via the heat conducting filling (930).

## Patentansprüche

1. LED-Lampe (100) umfassend:
- einen Metallkörper (200) mit einem zylindrischen Lumen;
- eine Leiterplatte (300) mit mehreren Einbaulöchern (310),
- eine LED (105), die innerhalb des Metallkörpers (200) in der Nähe eines fernen Endes des Metallkörpers angeordnet ist, wobei die LED mit einer oberen Schicht der Leiterplatte elektrisch gekoppelt ist;
- eine Verdrahtung (101), die die LED mit Energie versorgt, wobei die Verdrahtung an den mehreren Einbaulöchern (310) mit der Leiterplatte verbunden ist, und wobei die Verdrahtung aus einem nahen Ende des Metallkörpers hervorragt;
wobei die mehrschichtige Leiterplatte im zylindrischen Lumen in der Nähe des fernen Endes des Metallkörpers (200) eingebaut ist, und wobei die mehrschichtige Leiterplatte dazu eingerichtet ist, die Ableitung von Wärme von der LED (105) zu begünstigen, wobei die mehrschichtige Leiterplatte ferner umfasst:
- eine mittlere Metallschicht (602), die zwischen einer ersten Schicht von Leiterplattenmaterial (801) und einer zweiten Schicht von Leiterplattenmaterial (802) eingelassen ist, wobei die mittlere Metallschicht dazu eingerichtet ist, Wärme aufzunehmen und Wärme zur Verdrahtung (101) zu leiten; und
- eine untere Metallschicht (603), die an oder in der Nähe der zum nahen Ende des Metallkörpers (200) weisenden Fläche der Leiterplatte angeordnet ist, wobei die untere Metallschicht dazu eingerichtet ist, diffundierte Wärme aufzunehmen;
wobei das nahe Ende des zylindrischen Lumens mit einer Wärmeleitfüllung (930) gefüllt ist, die dazu eingerichtet ist, die von der unteren Metallschicht (603) aufgenommene Wärme zum Metallkörper (200) zu leiten,
**dadurch gekennzeichnet, dass** die untere Metallschicht (603) zwei Lötkontaktteile (603a, 603b) und einen von den beiden Lötkontakten (603a, 603b) elektrisch entkoppelten Wärmeleitteil (603c) umfasst, wobei der Wärmeleitteil (603c) den größten Teil der von den Lötkontakten (603a, 603b) nicht abgedeckten Fläche der unteren Metallschicht (603) abdeckt, und wobei der Wärmeleitteil (603c) dazu eingerichtet ist, diffundierte Wärme von der Leiterplatte (300) aufzunehmen und die aufgenommene diffundierte Wärme über die Wärmeleitfüllung (930) von der Leiterplatte weg zu leiten.

2. LED-Lampe nach Anspruch 1, wobei das ferne Ende des zylindrischen Lumens mit einer optischen Füllung (920) gefüllt ist, die die LED (105) und die Leiterplatte (300) gegen die Umgebung im fernen Ende des Körpers abdichtet, während die Wärmeleitfüllung (930) die Leiterplatte (300) gegen die Umgebung im nahen Ende des Körpers abdichtet.

3. LED-Lampe nach einem der Ansprüche 1 bis 2, wobei die Einbaulöcher (310) durch die Leiterplatte (300) hindurchgehen und zwei Leiter der Verdrahtung über zwei metallische Kabelverbinder (500) mit der Leiterplatte gekoppelt sind, wobei jeder Kabelverbinder ein in einem der Einbaulöcher (310) angeordnetes Ende und ein mit der Verdrahtung (101) gekoppeltes anderes Ende aufweist, wobei die Kabelverbinder mit der Leiterplatte mechanisch und elektrisch gekoppelt sind, indem die Einbaulöcher (310) mit Lotmaterial gefüllt werden, und wobei die Kabelverbinder (500) ferner Wärme von der mittleren Metallschicht (602) zur Verdrahtung (101) leiten.

4. LED-Lampe nach einem der Ansprüche 1 bis 3, wobei die mittlere Metallschicht (602) zwei elektrisch separate Teile einer Metallbeschichtung umfasst, die jeweils mit einem der Kabelverbinder (500) elektrisch gekoppelt sind, wobei die kombinierte Fläche der beiden Teile der mittleren Metallschicht den größten Teil der Fläche der mittleren Metallschicht abdeckt.

5. LED-Lampe nach einem der Ansprüche 1 bis 4, wobei die obere Metallschicht (601) und die mittlere Metallschicht (602) durch eine erste Schicht von Leiterplattenmaterial (801) getrennt sind und die mittlere Metallschicht (602) und die untere Schicht (603) durch eine zweite Schicht von Leiterplattenmaterial (802) getrennt sind, wobei die zweite Schicht (802) dicker als die erste Schicht (801) ist.

6. LED-Lampe nach Anspruch 5, wobei die untere Metallschicht (603) ferner durch eine dritte Schicht von Leiterplattenmaterial (803) von der nahen Fläche der Leiterplatte getrennt ist, wobei die dritte Schicht (803) dünner als die zweite Schicht (802) ist.

7. Verfahren zur Wärmeableitung in einer LED-Lampe, welche umfasst: einen Metallkörper (200) mit einem zylindrischen Lumen, eine Leiterplatte (300) mit mehreren Einbaulöchern (310), eine LED (105), die innerhalb des Metallkörpers in der Nähe eines fernen Endes des Metallkörpers angeordnet ist, eine Verdrahtung (101), die die LED mit Energie versorgt, wobei die Verdrahtung an den mehreren Einbaulöchern (310) mit der Leiterplatte (300) verbunden ist, und wobei die Verdrahtung aus einem nahen Ende des Metallkörpers (200) hervorragt, und wobei die mehrschichtige Leiterplatte (300) im zylindrischen Lumen in der Nähe des fernen Endes des Metallkörpers (200) eingebaut ist und dazu eingerichtet ist, die Ableitung von Wärme von der LED (105) zu begünstigen, wobei das Verfahren umfasst:
- Aufnehmen von Wärme durch eine mittlere Metallschicht (602), die zwischen einer ersten Schicht von Leiterplattenmaterial (801) und einer zweiten Schicht von Leiterplattenmaterial (802) eingelassen ist, und Leiten der aufgenommenen Wärme über die mittlere Metallschicht (602) zur Verdrahtung (101);
- Aufnehmen von diffundierter Wärme durch eine untere Metallschicht (603), die an oder in der Nähe der zum nahen Ende des Metallkörpers weisenden Fläche der Leiterplatte (300) angeordnet ist; und
- Leiten der von der unteren Metallschicht (603) aufgenommenen Wärme zum Metallkörper (200) über eine im nahen Ende des zylindrischen Lumens angeordnete Wärmeleitfüllung (930),
**dadurch gekennzeichnet, dass** die untere Metallschicht (603) zwei Lötkontaktteile (603a, 603b) und einen von den beiden Lötkontakten (603a, 603b) elektrisch entkoppelten Wärmeleitteil (603c) umfasst, wobei der Wärmeleitteil den größten Teil der von den Lötkontakten nicht abgedeckten Fläche der unteren Metallschicht (603) abdeckt, und wobei das Verfahren ferner umfasst:
- Aufnehmen von diffundierter Wärme von der Leiterplatte durch den Wärmeleitteil (603c), und
- Ableiten der aufgenommenen diffundierten Wärme über die Wärmeleitfüllung (930) von der Leiterplatte weg.

## Revendications

1. Lampe LED (100) comprenant :
- un corps métallique (200) avec une lumière cylindrique ;
- une carte de circuit imprimé (300) avec une pluralité de trous de montage (310) ;
- une LED (105) disposée à l'intérieur du corps métallique (200) à proximité d'une extrémité distale du corps métallique, ladite LED étant couplée électriquement à une couche supérieure de la carte de circuit imprimé ;
- une filerie (101) fournissant de l'énergie à la LED, ladite filerie étant couplée à la carte de circuit imprimé au droit de la pluralité de trous de montage (310), et ladite filerie débordant une extrémité proximale du corps métallique ;
ladite carte de circuit imprimé multicouche étant installée à l'intérieur de la lumière cylindrique à proximité de l'extrémité distale du corps métallique (200), et ladite carte de circuit imprimé multicouche étant configurée pour faciliter la dissipation de la chaleur de la LED (105), ladite carte de circuit imprimé multicouche comprenant également :
- une couche métallique centrale (602) en sandwich entre une première couche d'un matériau de circuit imprimé (801) et une deuxième couche d'un matériau de circuit imprimé (802), ladite couche métallique centrale étant configurée pour collecter de la chaleur et conduire de la chaleur vers la filerie (101) ; et
- une couche métallique inférieure (603) disposée au droit ou à proximité de la face de la carte de circuit imprimé qui est tournée vers l'extrémité proximale du corps métallique (200), ladite couche métallique inférieure étant configurée pour collecter de la chaleur diffusée ;
dans laquelle l'extrémité proximale de la lumière cylindrique est remplie d'une masse de remplissage thermoconductrice (930) configurée pour conduire vers le corps métallique (200) la chaleur collectée par la couche métallique inférieure (603),
**caractérisée en ce que** la couche métallique inférieure (603) comprend deux parties de plage d'accueil (603a, 603b) et une partie thermoconductrice (603c) électriquement découplée des deux plages d'accueil (603a, 603b), ladite partie thermoconductrice (603c) couvrant la majorité de la superficie de la couche métallique inférieure (603) non couverte par les plages d'accueil (603a, 603b), et ladite partie thermoconductrice (603c) étant configurée pour collecter la chaleur diffusée en provenance de la carte de circuit imprimé (300) et pour conduire la chaleur diffusée reçue à l'écart de la carte de circuit imprimé par le biais de la masse de remplissage thermoconductrice (930).

2. Lampe LED selon la revendication 1, dans laquelle l'extrémité distale de la lumière cylindrique est remplie d'une masse de remplissage optique (920) qui étanche la LED (105) et la carte de circuit imprimé (300) par rapport au milieu ambiant dans l'extrémité distale du corps, tandis que la masse de remplissage thermoconductrice (930) étanche la carte de circuit imprimé (300) par rapport au milieu ambiant dans l'extrémité proximale du corps.

3. Lampe LED selon l'une des revendications 1 à 2, dans laquelle les trous de montage (310) traversent la carte de circuit imprimé (300) et deux conducteurs de filerie sont couplés à la carte de circuit imprimé avec deux raccords de câble métalliques (500), chaque raccord de câble présentant une extrémité disposée dans l'un des trous de montage (310) et une autre extrémité couplée à la filerie (101), lesdits raccords de câble étant couplés mécaniquement et électriquement à la carte de circuit imprimé par remplissage des trous de montage (310) d'un matériau de brasage, et lesdits raccords de câble (500) conduisant également de la chaleur depuis la couche métallique centrale (602) vers la filerie (101).

4. Lampe LED selon l'une des revendications 1 à 3, dans laquelle la couche métallique centrale (602) comprend deux parties électriquement séparées d'un revêtement métallique, dont chacune est électriquement couplée à l'un des raccords de câble (500), la superficie combinée desdites deux parties de la couche métallique centrale couvrant la majorité de la superficie de la couche métallique centrale.

5. Lampe LED selon l'une des revendications 1 à 4, dans laquelle la couche métallique supérieure (601) et la couche métallique centrale (602) sont séparées par une première couche d'un matériau pour circuits imprimés (801), et la couche métallique centrale (602) et la couche inférieure (603) sont séparées par une deuxième couche d'un matériau pour circuits imprimés (802), ladite deuxième couche (802) étant plus épaisse que ladite première couche (801).

6. Lampe LED selon la revendication 5, dans laquelle la couche métallique inférieure (603) est également séparée de la face proximale de la carte de circuit imprimé par une troisième couche d'un matériau pour circuits imprimés (803), ladite troisième couche (803) étant moins épaisse que ladite deuxième couche (802).

7. Procédé de dissipation de chaleur dans une lampe LED comprenant un corps métallique (200) avec une lumière cylindrique, une carte de circuit imprimé (300) avec une pluralité de trous de montage (310), une LED (105) disposée à l'intérieur du corps métallique à proximité d'une extrémité distale du corps métallique, une filerie (101) fournissant de l'énergie à la LED (102), ladite filerie étant couplée à la carte de circuit imprimé (300) au droit de la pluralité de trous de montage (310), et ladite filerie débordant d'une extrémité proximale du corps métallique (200), et ladite carte de circuit imprimé multicouche (300) étant installée à l'intérieur de la lumière cylindrique à proximité de l'extrémité distale du corps métallique (200) et configurée pour faciliter la dissipation de la chaleur de la LED (105), ledit procédé comprenant les étapes consistant à
- collecter de la chaleur par une couche métallique centrale (602) en sandwich entre une première couche d'un matériau de circuit imprimé (801) et une deuxième couche d'un matériau de circuit imprimé (802), et conduire la chaleur collectée vers la filerie (101) par la couche métallique centrale (602) ;
- collecter de la chaleur diffusée, par une couche métallique inférieure (603) disposée au droit ou à proximité de la face de la carte de circuit imprimé (300) qui est tournée vers l'extrémité proximale du corps métallique ; et
- conduire la chaleur collectée par la couche métallique inférieure (603) vers le corps métallique (200) par le biais d'une masse de remplissage thermoconductrice (930) disposée dans l'extrémité proximale de la lumière cylindrique,
**caractérisé en ce que** la couche métallique inférieure (603) comprend deux parties de plage d'accueil (603a, 603b) et une partie thermoconductrice (603c) électriquement découplée des deux plages d'accueil (603a, 603b), ladite partie thermoconductrice couvrant la majorité de la superficie de la couche métallique inférieure (603) non couverte par les plages d'accueil, et ledit procédé comprenant également les étapes consistant à
- collecter de la chaleur diffusée de la carte de circuit imprimé par la partie thermoconductrice (603c), et
- conduire la chaleur diffusée reçue à l'écart de la carte de circuit imprimé par le biais de la masse de remplissage thermoconductrice (930).
